(19) **Europäisches Patentamt / European Patent Office / Office européen des brevets**

(11) **EP 2 756 577 B1**

(12) **FASCICULE DE BREVET EUROPEEN**

(45) Date de publication et mention
de la délivrance du brevet:
**31.08.2016 Bulletin 2016/35**

(21) Numéro de dépôt: **12773024.0**

(22) Date de dépôt: **12.09.2012**

(51) Int Cl.:
*H02M 3/02* (2006.01)       *H02J 1/00* (2006.01)
*H03H 7/01* (2006.01)       *H02J 1/14* (2006.01)
*H02J 3/16* (2006.01)       *H02J 3/24* (2006.01)
*B60R 16/03* (2006.01)       *G06F 17/10* (2006.01)

(86) Numéro de dépôt international:
**PCT/FR2012/052037**

(87) Numéro de publication internationale:
**WO 2013/038105 (21.03.2013 Gazette 2013/12)**

(54) **STABILISATION D'UN RESEAU ELECTRIQUE DC**

STABILISIERUNG EINES ELEKTRISCHEN DC NETZES

STABILIZATION OF AN ELECTRICAL DC GRID

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.09.2011 FR 1158205**

(43) Date de publication de la demande:
**23.07.2014 Bulletin 2014/30**

(73) Titulaires:
• **Labinal Power Systems
31700 Blagnac (FR)**
• **Université de Lorraine
54052 Nancy Cedex (FR)**

(72) Inventeurs:
• **VIEILLARD, Sébastien
F-77720 La Chapelle Gauthier (FR)**

• **MAGNE, Pierre
F-63110 Beaumont (FR)**
• **MEIBODY-TABAR, Farid
F-54600 Villers-les-Nancy (FR)**
• **NAHID-MOBARAKEH, Babak
F-54600 Villers-les-Nancy (FR)**
• **PIERFEDERICI, Serge
F-54840 Velaine-en-Haye (FR)**

(74) Mandataire: **Pichat, Thierry et al
Ernest Gutmann - Yves Plasseraud SAS
3, rue Auber
75009 Paris (FR)**

(56) Documents cités:
**US-A1- 2009 267 588**

**Description**

L'invention se rapporte à un procédé de stabilisation d'un réseau ou sous-réseau électrique DC à bus de tension continue, et par exemple d'un réseau ou sous-réseau HVDC (initiales de *High Voltage Direct Current* - courant continu haute tension). Ce réseau peut être embarqué dans un moyen de transport tel qu'un aéronef ou une automobile ou alimenter un bâtiment tel qu'une usine. Dans la présente demande, on entend par sous-réseau, un réseau local appartenant à un réseau électrique plus important.

Un réseau ou sous-réseau DC comprend typiquement une source de tension continue alimentant plusieurs charges électriques, telles que des convertisseurs (du type par exemple onduleur, actionneur, source de stockage (super-capacité), machine synchrone à aimants permanents, etc.), qui sont branchées en parallèle aux bornes de la source de tension et qui sont chacune destinées à recevoir une consigne de courant ou de puissance. Chaque charge peut donc correspondre à un équipement différent et n'ayant pas forcément de lien de communication avec les autres charges, et peut avoir son contrôle actif de charge indépendant.

Un réseau ou sous-réseau DC se différencie d'un réseau AC distribué par l'importance accrue de la contrainte liée à la stabilité du réseau à courant continu et de ses charges. L'ensemble des charges et le réseau lui-même doivent être normalement dimensionnés pour que leurs impédances respectives permettent d'avoir un réseau stable.

Un réseau DC est instable à un point de fonctionnement si le signal de tension ou de courant aux bornes de sa charge oscille et a une amplitude qui augmente au cours du temps.

Il est connu de stabiliser un réseau ou une charge de manière active ou passive.

La stabilisation passive d'une charge d'un réseau consiste à dimensionner son impédance de manière à satisfaire les critères de stabilité du réseau. Ceci se traduit par des surdimensionnements importants des éléments passifs (résistances et capacités) du réseau pour permettre la stabilisation du réseau suivant les différentes configurations. Cette solution n'est pas toujours satisfaisante car elle peut entraîner une augmentation de la taille et de la masse du réseau, ce qui présente un problème important lorsque ce réseau doit être embarqué, en particulier dans un aéronef. Par ailleurs, il est possible que ce surdimensionnement ne respecte pas certaines contraintes prévues initialement comme une fréquence de coupure d'un filtre ou autre. Par ailleurs, l'addition d'une charge à un tel réseau stabilisé de manière passive, peut entraîner une instabilité du réseau, même si la charge ajoutée au réseau est elle-même stable. Ceci montre que la stabilité des charges seules n'assure pas la stabilité du réseau comportant ces charges, l'interconnexion des charges sur un même bus pouvant conduire à l'instabilité de celui-ci. Une autre manière passive d'assurer la stabilité d'un réseau est de s'assurer, via l'intégration de saturations sur les consignes de référence des charges, que celles-ci ne consomment pas plus d'une certaine puissance sur le réseau.

L'article « Stabilisation of Constant-Power Load by Passive Impedance Damping » de Céspedés et al., in Applied Power Electronics Conference and Exposition (APEC), 2010 twenty-sixth Annual IEEE, p.2174-2180, décrit une méthode de stabilisation passive d'une charge par ajout d'un filtre au réseau, ce qui augmente l'amortissement du bus continu et accroît ainsi sa stabilité.

La stabilisation active d'une charge sur un réseau dédié consiste à modifier sa consigne de commande afin d'augmenter la stabilité du réseau. Cependant, cette solution est limitée car elle s'applique à un réseau simple comportant une seule charge.

L'article « Active Stabilisation of a Poorly Damped Input Filter Supplying a Constant Power Load » de Awan et al., In Proc. ECCE'09, décrit une méthode de stabilisation active d'une charge d'un réseau, qui propose un retour d'état spécifique basé sur le critère du cercle. Il est également connu de stabiliser un réseau à plusieurs charges de façon centralisée. Le réseau comprend alors un organe de stabilisation qui va acquérir des informations de l'ensemble du réseau et générer un vecteur contenant les signaux stabilisants de chaque charge et ainsi stabiliser l'ensemble du réseau.

L'article « Active Stabilisation of an HVDC Distribution system with Multiple Constant Power Loads » de Liu et al., IEEE Trans. Industrial Electronics, 2008, 54, n° 6, décrit la stabilisation active d'un réseau par l'implémentation de stabilisateurs locaux.

Cependant, toutes les solutions de stabilisation active d'une charge ou d'un réseau électrique de la technique actuelle ne sont pas entièrement satisfaisantes car on a constaté qu'en cas de défaut d'une des charges du réseau ou en cas de reconfiguration du réseau, la stabilisation du réseau n'est plus assurée.

L'invention a notamment pour but d'éviter ces Inconvénients de façon simple, efficace et économique.

Elle a pour objet un procédé de stabilisation active et décentralisée d'un réseau ou sous réseau DC.

Elle propose à cet effet un procédé de stabilisation d'un réseau électrique DC, ce réseau comportant une source de tension continue alimentant des charges électriques qui sont branchées en parallèle aux bornes de la source de tension et qui sont chacune destinées à recevoir une consigne de courant ou de puissance, caractérisé en ce que le réseau est stabilisé par régulation des consignes appliquées aux charges au moyen d'une impédance virtuelle de stabilisation générée aux bornes de chaque charge, ces impédances virtuelles étant dimensionnées pour stabiliser le réseau dans différents points de fonctionnement désirés et dans différentes configurations données du réseau comprenant l'état où au moins une charge est inactive ou en panne et l'état où la stabilisation d'une charge est inactive, chaque impédance virtuelle étant générée au moyen d'un bloc de stabilisation d'une boucle de régulation non linéaire qui agit sur la consigne de la charge correspondante et qui est apte à générer un signal de stabilisation $p_v(t)$ destiné à être superposé à la consigne de la charge pour augmenter le seuil de cette consigne au-delà duquel le réseau est instable, le signal de stabilisation étant du type

$$p_v(t) = v_s(t).C_v.dv_s/dt$$

ou

$$p_v(t) = K.v_s^2 - X_3$$

dans lesquelles $v_s$ représente la tension aux bornes de la charge, $C_v$ et K sont des paramètres définissant l'impédance virtuelle de stabilisation et $X_3$ est le signal de sortie d'un filtre de fréquence de coupure $w_c$ qui reçoit en entrée le signal $K.v_s^2$, plus le paramètre $C_v$ ou K est important et plus le signal de stabilisation est important, ce qui augmente le seuil de la consigne de la charge ou le seuil de la puissance maximale consommée par la charge, et garantit la stabilité du réseau.

$C_v$ représente une capacité virtuelle et K est un coefficient de correction équivalent à 1/R, 1/K représentant donc une résistance virtuelle. $C_v$ et K sont donc des paramètres définissant l'impédance virtuelle générée aux bornes de la charge.

Selon l'invention, le réseau DC est stabilisé par une approche décentralisée, par la mise en place d'un système de stabilisation multi-blocs. Le principe de cette approche est d'utiliser une structure décentralisée pour mettre en place un système de stabilisation multi-blocs sur le réseau DC. Ce système est composé de plusieurs blocs de stabilisation locaux indépendants installés sur chaque charge du système. De cette manière, on peut amortir le système devant chaque charge, limitant ainsi localement les sources d'instabilité. Ceci permet de stabiliser l'ensemble du réseau. L'aspect décentralisé de l'approche va contribuer à la fiabilité du système. Chaque bloc de stabilisation est indépendant des autres et localement disposé dans le réseau, aucune connexion ne sera nécessaire entre eux et un défaut sur l'un n'affectera pas les autres. De plus, un dimensionnement de l'ensemble des blocs permet de garantir la stabilité du système dans un certain nombre de scénarios de défauts.

De préférence, chaque boucle de régulation utilise une loi non linéaire de régulation générant un signal de sortie du type K.f(x), x étant une variable de commande de la charge et K étant un coefficient de correction propre à cette charge, les coefficients de correction ($K_1$, $K_2$, ..., $K_n$) étant déterminés en effectuant les étapes consistant à :

a) définir un modèle mathématique du réseau électrique, ce modèle comportant des équations comprenant les coefficients de correction ($K_1$, $K_2$, ..., $K_n$) précités pour assurer la stabilité des charges et du réseau ;
b) définir des contraintes à respecter pour que le réseau reste stable, notamment lors de reconfiguration du réseau ou de défaut d'au moins une charge ; et
c) déterminer un vecteur optimal de coefficients de correction au moyen d'un algorithme d'optimisation destiné à vérifier le respect des contraintes précitées pour un vecteur donné et à calculer une fonction objectif de stabilisation avec ce vecteur, puis à répéter ces étapes jusqu'à ce qu'un vecteur satisfasse aux contraintes à respecter.

Le procédé selon l'invention permet d'assurer la stabilité d'un réseau ou sous-réseau DC par la stabilisation des charges de ce réseau ou sous-réseau, et ce pour des points de fonctionnement définis quelle que soit la configuration et/ou les défauts du réseau. La stabilisation de chaque charge prend en compte l'impact de chaque charge sur la stabilisation du réseau global. Le procédé selon l'invention permet de moins ou de ne pas surdimensionner les éléments passifs du réseau en créant une impédance (par exemple une capacité ou une résistance) virtuelle en amont de chaque charge permettant la stabilisation des charges et de l'ensemble du réseau. Cette impédance virtuelle a pour but d'amortir les perturbations éventuellement générées sur le réseau ou aux bornes de la charge et est « dimensionnée » de manière à stabiliser le réseau dans les différents points de fonctionnement désirés, dans les différentes configurations réseau données, et dans les cas où au moins une charge est en défaut (c'est-à-dire qu'elle est désactivée ou eh panne).

L'impédance virtuelle générée aux bornes de chaque charge est obtenue par la régulation de la consigné de commande de la charge au moyen d'une loi non-linéaire et d'un coefficient de correction prédéterminé. Un vecteur comportant les coefficients de correction optimaux de toutes les charges est déterminé pour que les contraintes précitées soient respectées et qu'une fonction objectif soit réalisable.

L'étape a) peut par exemple consister à définir un modèle non linéaire du réseau et à le linéariser autour d'un point de fonctionnement ou à exprimer son jacobien.

Les contraintes à respecter à l'étape b) peuvent comprendre des plages de valeurs tolérées pour les coefficients de correction et le maintien de la stabilisation en cas de reconfiguration du réseau, de défaut de stabilisation d'au moins une charge, et de variations ou imprécisions dans les valeurs paramétriques propres au réseau.

La prise en compte des variations ou imprécisions dans les valeurs paramétriques propres au réseau permet de définir une marge de robustesse et de sécurité sur la stabilité.

Avantageusement, le modèle mathématique comprend des équations caractérisant le réseau en l'absence d'une ou plusieurs charges et/ou en l'absence de la stabilisation d'une ou plusieurs charges.

La stabilisation est ainsi robuste aux pannes et aux reconfigurations du réseau sans identification de la configuration en temps réel et sans modification des paramètres de régulation /stabilisation utilisés.

L'algorithme d'optimisation utilisé à l'étape c) est par exemple destiné à comparer le calcul de la fonction objectif avec un vecteur au calcul de cette fonction avec un autre vecteur dont les coefficients de correction sont les plus faibles possibles, puis à répéter ces étapes jusqu'à ce que le vecteur considéré minimise la fonction objectif définie. Celle-ci est choisie de telle sorte à orienter les efforts de stabilisation sur le réseau selon la volonté d'un concepteur (par exemple, minime sur les actionneurs, maximale sur les sources de stockage). N'importe quel algorithme d'optimisation sous contraintes peut être utilisé (génétique, méthode du gradient, etc.).

La présente invention concerne également un réseau électrique du type DC, selon la revendication 6, et donc comportant une source de tension alimentant des charges électriques qui sont branchées en parallèle aux bornes de la source de tension et qui sont chacune destinées à recevoir une consigne de courant ou de puissance, caractérisé en ce que chaque charge est stabilisée par la régulation de sa consigne au moyen d'un bloc de stabilisation ayant une entrée reliée à des moyens de mesure de la tension aux bornes de la charge et une sortie reliée à une borne d'application de la consigne de la charge par un sommateur relié également à des moyens d'émission d'une consigne.

Selon l'invention, un bloc de stabilisation local est implanté dans la boucle de régulation de chaque charge. Le fait que le réseau comprenne plusieurs blocs de stabilisation locaux entraîne une diminution des câbles nécessaires aux transmissions d'informations (mesures, référence du signal stabilisant) par rapport à l'intégration d'un bloc de stabilisation unique dans le réseau (pour une stabilisation centralisée) qui doit être relié à un grand nombre de capteurs pour ramener toutes les mesures à ce bloc. L'intégration de blocs de stabilisation locaux au réseau permet également de diminuer le nombre de capteurs mis en jeu car seules les tensions aux bornes des charges sont nécessaires.

Le bloc de stabilisation extrait la composante haute fréquence de la tension, c'est à dire qu'il doit filtrer sa composante continue. A titre d'exemple, ce filtrage peut être réalisé à l'aide d'un filtre passe-bas et d'un soustracteur, l'entrée du filtre étant reliée aux moyens de mesure précités et sa sortie étant reliée au soustracteur, qui est destiné à soustraire le signal de sortie du filtre au signal provenant des moyens de mesure. En variante, on peut utiliser des filtres passe-haut ou passe-bande.

Chaque impédance virtuelle est générée par un convertisseur alimentant la charge (tel qu'un onduleur, buck, boost...) au moyen d'un bloc de stabilisation générant un retour d'état non linéaire et qui est transmis au convertisseur en étant superposé sur la consigne de la charge correspondante. Le bloc de stabilisation est apte à générer un signal de stabilisation $p_v(t)$ destiné à être superposé à la consigne de la charge pour augmenter le seuil de la puissance maximale pouvant être consommée par la charge sur le réseau au-delà duquel celui-ci est instable, le signal de stabilisation étant du type

$$p_v(t) = v_s(t).C_v.dv_s/dt$$

ou

$$p_v(t) = K.v_s{}^2 - X_3$$

dans lesquelles $v_s$ représente la tension aux bornes duu convertisseur de puissance contrôlant la charge, $C_v$ et $K$ sont des paramètres définissant l'impédance virtuelle de stabilisation et $X_3$ est le signal de sortie d'un filtre de fréquence de coupure $w_c$ qui reçoit en entrée le signal $K.v_s^2$,

plus le paramètre $C_v$ ou $K$ est important et plus le signal de stabilisation est important, ce qui augmente le seuil de la puissance maximale pouvant être consommée par la charge sur le réseau et garanti la stabilité de l'interaction entre la charge et le réseau.

Le modèle mathématique du réseau électrique défini précédemment peut alors être muni des retours d'état stabilisants.

La présente invention concerne encore un moyen de transport, tel qu'un aéronef, caractérisé en ce qu'il comprend un réseau électrique stabilisé tel que décrit ci-dessus.

L'invention sera mieux comprise et d'autres détails, avantages et caractéristiques de l'invention apparaîtront à la lecture de la description suivante faite à titre d'exemple non limitatif, en référence aux dessins annexés dans lesquels :

- la figure 1 représente une architecture d'un réseau électrique DC comportant une source de tension continue et trois charges ;
- la figure 2 représente un réseau électrique DC simplifié comprenant une source de tension et une seule charge qui est stabilisée activement par la création d'une impédance virtuelle Z à ses bornes ;
- la figure 3 représente un réseau électrique DC similaire à celui de la figure 1 et comprenant des blocs de stabilisation locaux destinés à créer virtuellement des impédances pour stabiliser les charges ;
- les figures 4a et 4b représentent chacune un bloc de stabilisation d'une charge d'un réseau DC ;
- les figures 5 et 6 sont des schémas blocs représentant des étapes du procédé selon l'invention ;
- la figure 7 est un graphe illustrant l'évolution de la tension de bus DC sur les trois charges du réseau de la figure 1 en réponse à un échelon de puissance, lorsque ces trois charges ne sont pas stabilisées ; et
- les figures 8 et 9 sont des graphes illustrant l'évolution de la tension de bus DC sur les trois charges du réseau de la figure 3 en réponse à un échelon de puissance, lorsque ces trois charges sont stabilisées dans le cas de la figure 8, et lorsque seulement deux charges sont stabilisées, la fonction stabilisante d'une charge étant en défaut dans le cas de la figure 9.

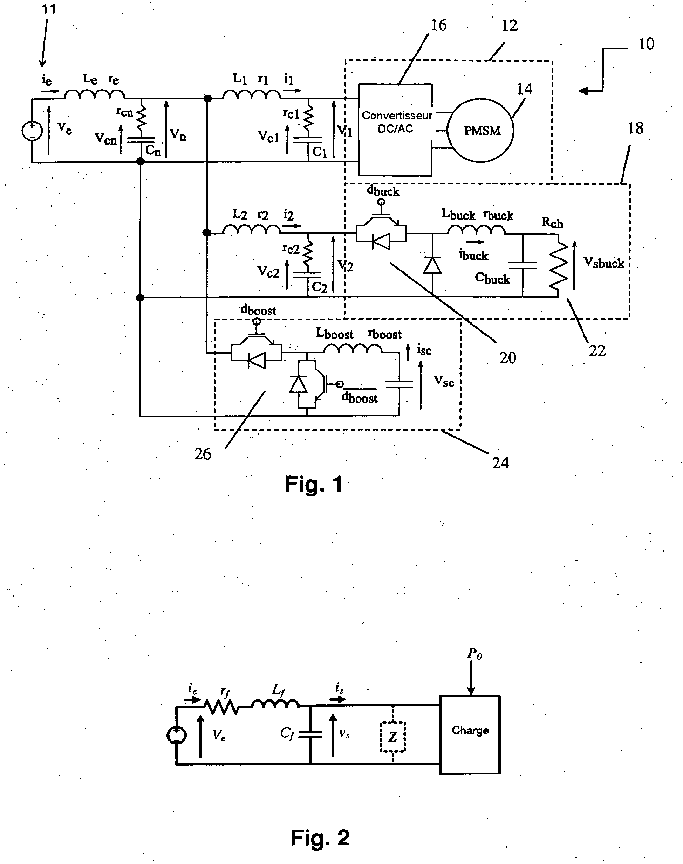

On se réfère d'abord à la figure 1 qui représente un réseau électrique DC 10 qui peut être embarqué dans un moyen de transport tel qu'un aéronef, ce réseau comprenant une source 11 de tension continue dont les bornes de sortie sont reliées en parallèle aux bornes d'entrée de trois charges différentes.

La première charge 12 comprend une machine synchrone à aimants permanents 14 (MSAP ou PMSM, acronyme de *Permanent Magnet Synchronous Machine)* alimentée par un onduleur triphasé 16 régulé en couple via une commande vectorielle d-q classique.

La deuxième charge 18 comprend un convertisseur DC/DC 20 débitant sur une simple résistance 22, l'ensemble étant régulé en puissance de sorte que l'on dispose ainsi d'une charge consommant une puissance parfaitement maîtrisée sur le réseau.

La troisième charge 24 est une super-capacité (SC) qui est connectée au réseau via un autre convertisseur DC/DC 26 bidirectionnel en courant. L'ensemble est également régulé en puissance. On peut ainsi contrôler les échanges de puissance entre la SC et le réseau.

La tension du bus DC est $v_n$ et les tensions aux bornes des trois charges sont respectivement $v_1$, $v_2$ et $v_n$.

Le réseau ou sous-réseau DC selon l'invention est par exemple un boitier du type EBAC, un sous réseau ELS *(Landing Gear system)* ou EFCS *(Flight Control System)*, un boitier de distribution primaire type PRIMES, etc.

Les charges du réseau 10 sont suffisamment bien asservies pour que l'on puisse les considérer comme fonctionnant à puissance constante. La tension d'entrée $V_e$ est aussi supposée parfaitement constante. La stabilité d'une charge peut être étudiée individuellement avant de traiter le cas où les trois charges sont simultanément connectées sur le réseau. La stabilité de chaque charge peut être étudiée par l'étude des tracés fréquentiels de Nyquist de la FTBO des systèmes pour les configurations en cascade (1 charge). La stabilité du réseau global (3 charges) est appréciée par l'étude des zéros du dénominateur d'une fonction de transfert, qui est pour chaque charge la fonction de transfert du rapport de la tension $v_s$ aux bornes de la charge ($v_1$, $v_2$ ou $v_n$) sur la tension d'entrée $V_e$ ($v_s/V_e$). Les résultats obtenus peuvent être confirmés par simulation, comme on le verra dans ce qui suit.

Comme décrit précédemment, les configurations électriques des réseaux peuvent être instables si la consigne de commande (par exemple de puissance) des charges dépasse un certain seuil. Cette limite de puissance est définie par la structure du réseau ainsi que son contenu, c'est à dire par la valeur des paramètres qui le composent. Il est connu que la valeur des éléments passifs comme les capacités, les résistances ou les inductances varient en fonction de plusieurs paramètres qui ne sont pas toujours maîtrisables et/ou constantes. On peut prendre en exemple les variations de température ou le vieillissement qui agissent sur les propriétés électriques des systèmes. Tout ceci va donc entraîner une modification des propriétés de stabilité du système pouvant l'amener dans un état d'instabilité. Afin de contrer ce phénomène non désiré, l'invention propose de définir des commandes adaptées qui généreront des signaux dits stabilisants, qui viendront se superposer aux références des charges et permettront d'assurer totalement ou d'augmenter la stabilité du système. Ces signaux sont avantageusement nuls en régime permanent dans le but de ne pas perturber ou modifier les consignes souhaitées par un utilisateur ou un point de fonctionnement original.

La modification des paramètres de consigne des charges entraîne une modification du point de fonctionnement du réseau. Autrement dit, pour chaque point de fonctionnement du réseau sont définis des paramètres de consigne des différentes charges. Par exemple, on définit un point de fonctionnement correspondant à $i_q = 7A$, $P_2 = 500W$, $P_{sc} = 0W$.

Le procédé selon l'invention permet de moins ou de ne pas surdimensionner les éléments passifs du réseau en créant une impédance Z (capacité, résistance ou autre) virtuelle en amont de chaque charge permettant la stabilisation des charges et de l'ensemble du réseau (figure 2). Cette impédance virtuelle a pour but d'amortir les perturbations éventuellement générées sur le réseau ou aux bornes de la charge et est « dimensionnée » de manière à stabiliser le réseau dans les différents points de fonctionnement désirés, dans les différentes configurations réseau données, et dans les cas où au moins une charge est en défaut (c'est-à-dire qu'elle est désactivée ou est en panne).

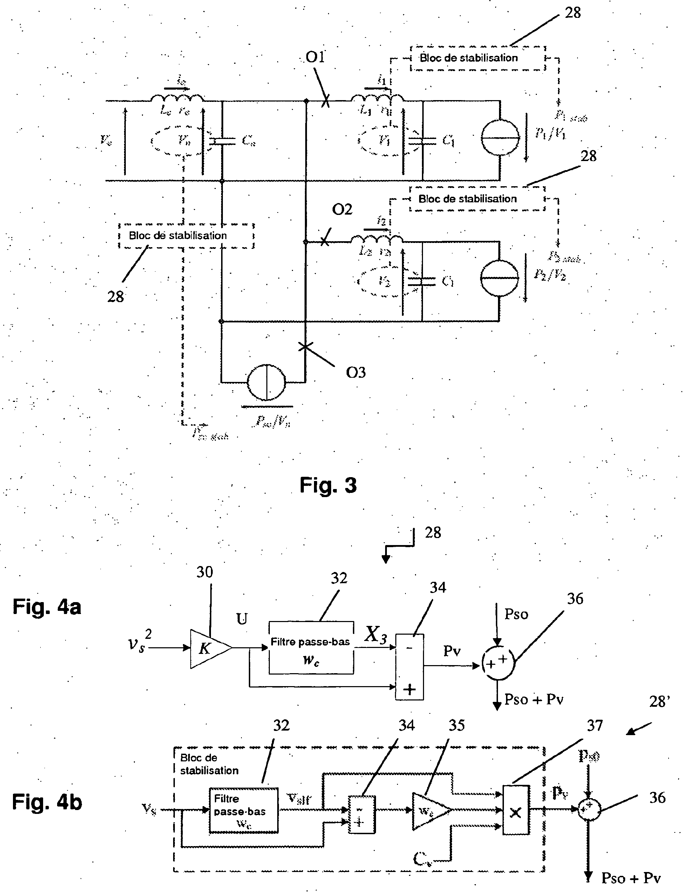

Selon l'invention, l'impédance de stabilisation de chaque charge est générée à partir d'un bloc de stabilisation 28 (figure 3) qui agit directement sur la boucle de consigne de la charge, pour réguler cette consigne et assurer la stabilité notamment en :

- ajustant les variations de la consigne entre les différents points de fonctionnement demandés ;
- assurant la stabilité du réseau lorsqu'au moins l'un des blocs de stabilisation n'est plus actif ; et
- assurant la stabilité du réseau lorsqu'au moins l'une des charges est déconnectée (reconfiguration du réseau).

Le bloc de stabilisation 28 de la figure 4a permet de générer une résistance virtuelle aux bornes d'une charge. Le bloc 28 comprend un moyen 30 de multiplication de la tension $v_s$ mesurée aux bornes de la charge par un gain ou coefficient de correction K (équivalent à 1/R) directement proportionnel à l'amplitude du signal stabilisant, pour produire un signal U. L'entrée d'un filtre passe bas 32 de fréquence de coupure $w_c$ est reliée à la sortie du moyen 30 et reçoit donc le signal U. Le signal de sortie $X_3$ du filtre 32 est soustrait au signal U au moyen d'un soustracteur 34. Le signal de sortie $P_v$ du soustracteur 34 est additionné au signal $P_{so}$ de la consigne de la charge par un sommateur 36 dont la sortie est reliée à la charge.

La pulsation ou fréquence de coupure $w_c$ est dimensionnée de manière à ce que seules les variations de tension soient vues par les stabilisateurs locaux, leurs composantes continues étant supprimées. La valeur numérique choisie doit intégrer le fait que toutes les fréquences voisines des fréquences de résonance générées par les filtres d'interconnexion de l'ensemble du réseau doivent pouvoir être prises en compte par chaque bloc de stabilisation local. La variante de réalisation du bloc de stabilisation 28' de la figure 4b permet de générer une capacité virtuelle $C_v$ aux bornes d'une charge. Ce bloc 28' comprend également un filtre passe bas 32 de fréquence de coupure $w_c$ qui reçoit en entrée la tension $v_s$ du bus DC et dont la sortie est notée $v_{slf}$. Un soustracteur 34 permet de retrancher le signal filtré $v_{slf}$ au signal $v_s$. Le signal de sortie du soustracteur 34 correspond à une oscillation haute fréquence qui est multipliée par la fréquence de pulsation du filtre passe bas par un moyen 35 de multiplication de gain $w_c$. Le signal de sortie du moyen 35 et le signal $v_{slf}$ sont transmis à un moyen 37 supplémentaire de multiplication pour produire un signal régulé de puissance $p_v$, en fonction de la capacité virtuelle $C_v$ à générer aux bornes de la charge.

Le modèle mathématique pour étudier la stabilité de la tension du bus DC d'une charge telle que représentée en figure 2 (pour lequel $P_s = P_{so}$ est la puissance d'entrée ou de consigne de la charge pour un point de fonctionnement ($i_{eo}$, $v_{so}$) ; $P_{so} = v_{so}.i_{e0}$ étant supposée être constante), peut être exprimé de la façon suivante :

$$\begin{cases} L_f \cdot \dfrac{d}{dt} i_e = -r_f \cdot i_e - v_s + V_e \\ C \cdot \dfrac{d}{dt} v_s = i_e - \dfrac{P_s}{v_s} \end{cases} \qquad (1)$$

dans lequel $L_f$ représente une inductance, ie représente le courant délivré par la source de tension $V_e$, rf représente une résistance, $v_s$ représente la tension aux bornes de la charge, Ve représente la tension, C ou $C_f$ représente une capacité qui forme avec l'inductance $L_f$ un filtre LC.

Pour simplifier ce modèle, il est considéré que la commande de la charge est efficace et donc que les variations de la tension du bus DC ont peu ou pas d'influence sur les courants commandés de la charge.

L'analyse de la stabilité du signal de la charge représentée en figure 2 peut être effectuée en étudiant les pôles du modèle mathématique localement linéarisé autour d'un point de fonctionnement. Ceci amène aux critères suivants qui donnent la puissance de charge maximale admissible pour un point de fonctionnement stable :

$$\begin{cases} p_{so} < p_{so\ max} \\ p_{so\ max} = r_f \dfrac{C_f}{L_f} v_{so}^2 \end{cases} \qquad (2)$$

dans lequel $v_{so}$ est la tension aux bornes de la charge pour le point de fonctionnement considéré.

Dans le cas où la consigne de puissance ($P_{so}$) de la charge atteindrait $P_{so\ max}$, cette charge ne serait plus stable. $P_{so\ max}$ représente donc un seuil qui ne doit pas être atteint par la consigne $P_{so}$. Comme il ressort des équations ci-dessus, $P_{so\ max}$ est directement proportionnel à la capacité C. L'augmentation de cette capacité, par l'addition d'une capacité virtuelle supplémentaire aux bornes de la charge, permet d'augmenter le Seuil Pso $_{max}$.

En pratique, cette capacité virtuelle est générée en injectant une puissance additionnelle $P_v$ à la consigne de puissance $P_s$, cette puissance additionnelle répondant à la formule suivante et représentant le signal de stabilisation de la charge délivré par le bloc de stabilisation (lorsque $P_v = 0$, la charge n'est pas stabilisée) :

$$(3) \qquad p_v(t) = v_s(t).i_v(t) = v_s(t).C_v \frac{dv_s}{dt}$$

dans lequel $C_v$ est la capacité virtuelle générée en amont de la charge par le bloc de stabilisation, et $i_v$ est le courant traversant cette capacité.

Pour connaître l'influence du bloc de stabilisation sur l'impédance, il est nécessaire d'intégrer le courant supplémentaire $i_v$ aux bornes de la charge, dans le modèle précité. Pour cela, le modèle intègre une dérivée filtrée de la mesure de la tension du bus DC ($v_s$), ce modèle étant du type :

$$(4) \qquad \begin{cases} \dot{x}_1 = -\dfrac{r_f}{L_f}x_1 - \dfrac{x_2}{L_f} \\[2mm] \dot{x}_2 = \dfrac{p_{s0}x_2 - C_v w_c v_{s0}(x_3 + v_{s0})(x_2 - x_3)}{C_f v_{s0}(x_2 + v_{s0})} + \dfrac{x_1}{C_f} \\[2mm] \dot{x}_3 = w_c(x_2 - x_3) \end{cases}$$

Ces équations représentent le modèle mathématique du réseau de la figure 2, stabilisé par un bloc de stabilisation, dans lequel les variables d'état sont :

$$(5) \qquad \begin{cases} x_1 = i_e - i_{e0} \\ x_2 = v_s - v_{s0} \\ x_3 = v_{slf} - v_{s0} \end{cases}$$

avec les paramètres suivants du point de fonctionnement ($i_{eo}$, $v_{so}$) :

$$(6) \qquad \begin{cases} i_{e0} = \dfrac{p_{s0}}{v_{s0}} \\[2mm] v_{s0} = \dfrac{V_e + \sqrt{V_e^2 + 4p_{s0}r_f}}{2} \end{cases}$$

et dans lequel, pour un filtre de premier ordre, $v_{slf}$ est une variable d'état additionnelle.

Les variables d'état $x_1$, $x_2$ et $x_3$ précitées sont fonction de paramètres physiques mesurables ou de données du réseau.

pour stabiliser une charge, on peut aussi proposer la loi de stabilisation suivante, dans laquelle K est le coefficient de correction (1/K représente une résistance virtuelle, K étant équivalent à 1/R) à définir pour stabiliser la charge : U = K.$v_s^2$ et $p_v(t) = K.v_s^2 - X_3$ (cf. figure 4a).

$p_v(t) = K.v_s^2-X_3$ représente le signal de stabilisation d'une charge dans le cas de la figure 4a pour un large signal, ce signal étant exprimé sous la forme K.f(x) autour d'un point de fonctionnement donné.

La détermination des paramètres K dépend notamment de l'architecture du réseau et du nombre de charges actives de ce réseau. Ces paramètres sont déterminés d'une part par la résolution de l'ensemble des matrices définissant le réseau, et d'autre part en fonction des différents points de fonctionnement désirés, des différentes configurations possibles, et de critères de minimisation de l'influence des performances dynamiques sur les charges.

La loi de stabilisation intègre un amortissement du signal et prend en compte le fait que les oscillations non amorties sont destinées à disparaître. Du fait que cet amortissement est seulement nécessaire autour d'un point de fonctionnement, il doit être suivi d'un filtre approprié, par exemple un filtre passe bas, comme représenté aux figures 4a et 4b.

[0057]   - Le réseau de la figure 3 est modélisé et linéarisé à un point de fonctionnement donné. Ce réseau correspond au réseau de la figure 1 dans lequel des blocs de stabilisation selon l'invention ont été ajoutés, chaque bloc étant destiné à réguler la consigne de commande de la charge à laquelle il est associé de façon à la stabiliser au sein du réseau

Le modèle mathématique linéaire du réseau DC peut être défini par la matrice suivante (Msain), dans laquelle les paramètres $K_1$, $K_2$ et $K_{sc}$ représentent respectivement les coefficients de correction de la première, de la deuxième et de la troisième charge.

$$\begin{bmatrix} \dot{\tilde{x}}_1(t) \\ \dot{\tilde{x}}_2(t) \\ \dot{\tilde{x}}_3(t) \\ \dot{\tilde{x}}_4(t) \\ \dot{\tilde{x}}_5(t) \\ \dot{\tilde{x}}_6(t) \\ \dot{\tilde{x}}_7(t) \\ \dot{\tilde{x}}_8(t) \\ \dot{\tilde{x}}_9(t) \end{bmatrix} = \underbrace{\begin{bmatrix} \frac{-r_e}{L_e} & 0 & 0 & \frac{-1}{L_e} & 0 & 0 & 0 & 0 & 0 \\ 0 & \frac{-r_1}{L_1} & 0 & \frac{1}{L_1} & \frac{-1}{L_1} & 0 & 0 & 0 & 0 \\ 0 & 0 & \frac{-r_2}{L_2} & \frac{1}{L_2} & 0 & \frac{-1}{L_2} & 0 & 0 & 0 \\ \frac{1}{C_n} & \frac{-1}{C_n} & \frac{-1}{C_n} & \frac{P_{sc}}{v_{n0}^2 C_n} - 2\frac{K_{sc}}{C_n} & 0 & 0 & \frac{1}{C_n v_{n0}} & 0 & 0 \\ 0 & \frac{1}{C_1} & 0 & 0 & \frac{P_1}{v_{10}^2 C_1} - 2\frac{K_1}{C_1} & 0 & 0 & \frac{1}{C_1 v_{10}} & 0 \\ 0 & 0 & \frac{1}{C_2} & 0 & 0 & \frac{P_2}{v_{20}^2 C_2} - 2\frac{K_2}{C_2} & 0 & 0 & \frac{1}{C_2 v_{20}} \\ 0 & 0 & 0 & 2K_{sc} V_{n0} w_{sc} & 0 & 0 & -w_{sc} & 0 & 0 \\ 0 & 0 & 0 & 0 & 2K_1 V_{10} w_1 & 0 & 0 & -w_1 & 0 \\ 0 & 0 & 0 & 0 & 0 & 2K_2 V_{20} w_2 & 0 & 0 & -w_2 \end{bmatrix}}_{M_{sain}} \begin{bmatrix} \tilde{x}_1(t) \\ \tilde{x}_2(t) \\ \tilde{x}_3(t) \\ \tilde{x}_4(t) \\ \tilde{x}_5(t) \\ \tilde{x}_6(t) \\ \tilde{x}_7(t) \\ \tilde{x}_8(t) \\ \tilde{x}_9(t) \end{bmatrix} \quad (2.1)$$

Une fonction objectif est déterminée pour stabiliser le réseau en fonction de contraintes qui seront décrites plus en détail dans ce qui suit. Cette fonction objectif peut être exprimée par l'équation suivante :

$$f_{min}(K_1, K_2, K_{sc}) = K_1 + K_2 + \frac{1}{K_{sc}}$$

Les contraintes vont garantir la stabilité du système. Elles seront imposées aux parties réelles des valeurs propres $\lambda$ des matrices d'état du système dans ses différentes configurations. Les contraintes étant valables localement autour d'un point de fonctionnement, on étudiera la stabilité de tous les points de fonctionnement correspondant à un domaine D donné par deux intervalles de puissance, tel qu'il est défini par la relation suivante :

$$\begin{cases} D \in \Re^2, I_1 \in \Re, I_2 \in \Re \\ I_1 = [0; P_{1max}] \; et \; I_2 = [0; P_{2max}] \\ D = I_1 \times I_2 \end{cases}$$

et ceci pour les cas suivants :

(a) au moins deux des stabilisateurs sont actifs sur les trois (possibilité de panne sur l'un des trois) ;
(b) déconnexion de l'une des branches du système (déconnexion automatique par sécurité).

Dans les scénarios de défaut, on va donc prendre en compte l'événement et ce qu'il implique sur le système par l'algorithme chargé de l'optimisation qui, s'il parvient à converger, donnera un dimensionnement des blocs de stabilisation qui assure la stabilité de l'ensemble des cas considérés. On peut rappeler qu'assurer la stabilité locale pour tous les points de fonctionnement d'un domaine, ne correspond pas à assurer la stabilité large signal dans ce domaine.

D'autres contraintes à prendre en compte concernent les cas de reconfiguration du réseau, par exemple en cas de défaut sur une branche du réseau.

La matrice $M_{défaut1}$ suivante est une modélisation mathématique du réseau dans le cas où une branche de la première charge est ouverte, par exemple au point O1 en figure 3.

$$
\begin{bmatrix} \dot{x}_1(t) \\ \dot{x}_3(t) \\ \dot{x}_4(t) \\ \dot{x}_6(t) \\ \dot{x}_7(t) \\ \dot{x}_9(t) \end{bmatrix} = \underbrace{\begin{bmatrix} \dfrac{-r_e}{L_e} & 0 & \dfrac{-1}{L_e} & 0 & 0 & 0 \\ 0 & \dfrac{-r_2}{L_2} & \dfrac{1}{L_2} & \dfrac{-1}{L_2} & 0 & 0 \\ \dfrac{1}{C_n} & \dfrac{-1}{C_n} & \dfrac{P_{sc}}{v_{n0}^2 C_n}-2\dfrac{K_{sc}}{C_n} & 0 & \dfrac{1}{C_n v_{n0}} & 0 \\ 0 & \dfrac{1}{C_2} & 0 & \dfrac{P_2}{v_{20}^2 C_2}-2\dfrac{K_2}{C_2} & 0 & \dfrac{1}{C_2 v_{20}} \\ 0 & 0 & 2K_{sc}V_{n0}w_{sc} & 0 & -w_{sc} & 0 \\ 0 & 0 & 0 & 2K_2 V_{20}w_2 & 0 & -w_2 \end{bmatrix}}_{M_{defaut\,1}} \begin{bmatrix} x_1(t) \\ x_3(t) \\ x_4(t) \\ x_6(t) \\ x_7(t) \\ x_9(t) \end{bmatrix}
$$

La matrice $M_{\text{défaut2}}$ suivante est une modélisation mathématique du réseau dans le cas où une branche de la deuxième charge est ouverte, par exemple au point 02 en figure 3.

$$
\begin{bmatrix} \dot{x}_1(t) \\ \dot{x}_2(t) \\ \dot{x}_4(t) \\ \dot{x}_5(t) \\ \dot{x}_7(t) \\ \dot{x}_8(t) \end{bmatrix} = \underbrace{\begin{bmatrix} \dfrac{-r_e}{L_e} & 0 & \dfrac{-1}{L_e} & 0 & 0 & 0 \\ 0 & \dfrac{-r_1}{L_1} & \dfrac{1}{L_1} & \dfrac{-1}{L_1} & 0 & 0 \\ \dfrac{1}{C_n} & \dfrac{-1}{C_n} & \dfrac{P_{sc}}{v_{n0}^2 C_n}-2\dfrac{K_{sc}}{C_n} & 0 & \dfrac{1}{C_n v_{n0}} & 0 \\ 0 & \dfrac{1}{C_1} & 0 & \dfrac{P_1}{v_{10}^2 C_1}-2\dfrac{K_1}{C_1} & 0 & \dfrac{1}{C_1 v_{10}} \\ 0 & 0 & 2K_{sc}V_{n0}w_{sc} & 0 & -w_{sc} & 0 \\ 0 & 0 & 0 & 2K_1 V_{10}w_1 & 0 & -w_1 \end{bmatrix}}_{M_{defaut\,2}} \begin{bmatrix} x_1(t) \\ x_2(t) \\ x_4(t) \\ x_5(t) \\ x_7(t) \\ x_8(t) \end{bmatrix}
$$

La matrice $M_{\text{défautsc}}$ suivante est une modélisation mathématique du réseau dans le cas où une branche de la troisième charge est ouverte, par exemple au point 03 en figure 3.

$$
\begin{bmatrix} \dot{x}_1(t) \\ \dot{x}_2(t) \\ \dot{x}_3(t) \\ \dot{x}_4(t) \\ \dot{x}_5(t) \\ \dot{x}_6(t) \\ \dot{x}_8(t) \\ \dot{x}_9(t) \end{bmatrix} = \underbrace{\begin{bmatrix} \dfrac{-r_e}{L_e} & 0 & 0 & \dfrac{-1}{L_e} & 0 & 0 & 0 & 0 \\ 0 & \dfrac{-r_1}{L_1} & 0 & \dfrac{1}{L_1} & \dfrac{-1}{L_1} & 0 & 0 & 0 \\ 0 & 0 & \dfrac{-r_2}{L_2} & \dfrac{1}{L_2} & 0 & \dfrac{-1}{L_2} & 0 & 0 \\ \dfrac{1}{C_n} & \dfrac{-1}{C_n} & \dfrac{-1}{C_n} & 0 & 0 & 0 & 0 & 0 \\ 0 & \dfrac{1}{C_1} & 0 & 0 & \dfrac{P_1}{v_{10}^2 C_1}-2\dfrac{K_1}{C_1} & 0 & \dfrac{1}{C_1 v_{10}} & 0 \\ 0 & 0 & \dfrac{1}{C_2} & 0 & 0 & \dfrac{P_2}{v_{20}^2 C_2}-2\dfrac{K_2}{C_2} & 0 & \dfrac{1}{C_2 v_{20}} \\ 0 & 0 & 0 & 0 & 2K_1 V_{10}w_1 & 0 & -w_1 & 0 \\ 0 & 0 & 0 & 0 & 0 & 2K_2 V_{20}w_2 & 0 & -w_2 \end{bmatrix}}_{M_{defaut\,sc}} \begin{bmatrix} x_1(t) \\ x_2(t) \\ x_3(t) \\ x_4(t) \\ x_5(t) \\ x_6(t) \\ x_8(t) \\ x_9(t) \end{bmatrix}
$$

Afin d'intégrer un critère de robustesse, on va imposer aux parties réelles des valeurs propres des matrices $M_{sain}$, $M_{defaut1}$, $M_{defautsc}$ et $M_{defaut2}$ d'être inférieures à une valeur strictement négative notée MR. Ceci assurera une marge de sécurité pour prendre en compte les éventuelles variations et imprécisions sur les valeurs paramétriques. Finalement, les contraintes à respecter se traduisent par la relation :

$$
\begin{cases}
g_1 = max\{\Re(\lambda_{M_{sain}})\} + MR \\
g_2 = max\{\Re(\lambda_{M_{sain}, K_1=0})\} + MR \\
g_3 = max\{\Re(\lambda_{M_{sain}, K_2=0})\} + MR \\
g_4 = max\{\Re(\lambda_{M_{sain}, K_n=0})\} + MR \\
g_5 = max\{\Re(\lambda_{M_{defaut\,1}})\} + MR \\
g_6 = max\{\Re(\lambda_{M_{defaut\,2}})\} + MR \\
g_7 = max\{\Re(\lambda_{M_{defaut\,sc}})\} + MR
\end{cases}
$$

Toute autre contrainte exprimée sous forme d'équations peut être prise en compte dans l'algorithme.

La linéarisation du système permet de définir les valeurs propres du système, en jouant sur les différentes valeurs de K, les parties réelles de chaque pôle sont rendues négatives (ce qui garantit la stabilité dans le domaine proche des points de linéarisation), et sont avantageusement rendues inférieures à -5 pour augmenter les marges de robustesse du système.

Ensuite, en fonction par exemple des différents points de fonctionnement désirés, des différentes configurations possibles, et de critères de minimisation de l'influence des performances dynamiques sur les charges, les différentes valeurs de K répondant à l'ensemble de ces critères sont déterminées pour assurer la stabilité du réseau.

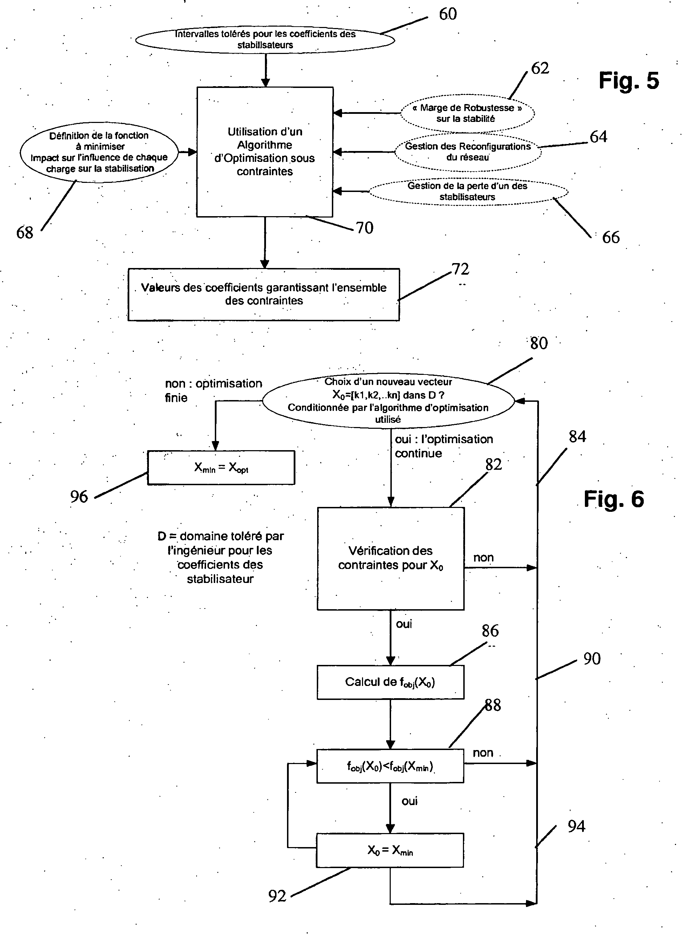

La figure 5 représente très schématiquement les étapes du procédé selon l'invention de détermination des coefficients de correction qui sont appliqués aux consignes des charges pour les stabiliser au sein du réseau DC. Cette figure illustre les contraintes qui peuvent être prises en compte pour la définition des coefficients de correction.

Dans l'exemple représenté, les contraintes prises en compte sont :

a) des intervalles tolérés pour les coefficients K des blocs de stabilisation (bloc 60) ;
b) une marge de robustesse sur la stabilité de chaque charge (bloc 62);
c) la gestion des reconfigurations du réseau (bloc 64); et
d) la gestion de la perte d'un des blocs de stabilisation (bloc 66).

Le modèle du réseau établi ci-dessus permet de définir la fonction objectif à minimiser et d'apprécier l'impact de chaque charge sur la stabilisation (bloc 68).

La modélisation du réseau, de ses points de fonctionnements, de ses modes dégradés tolérés souhaités permettent de définir un ensemble d'équations permettant de définir un unique jeu de valeurs de coefficients (K1 à Kn). L'intérêt de cette unique solution permet de faire en sorte que les valeurs définies sont robustes et uniques pour tous les cas souhaités et pris en compte dans la modélisation et le système d'équations.

Un algorithme d'optimisation est ensuite utilisé pour itérer et trouver les meilleures valeurs de K répondant aux critères d'optimisation (blocs 70 et 72). L'algorithme de calcul et d'optimisation n'est pas spécifique, et peut par exemple être la fonction *fmincon* de matlab qui résout et optimise l'ensemble des équations. Ceci permet de définir les valeurs des coefficients de correction K précités.

L'objectif de la stabilisation décentralisée ou multi-blocs est de proproser un dimensionnement cohérent des blocs de stabilisation qui assure la stabilité du système dans plusieurs cas. Afin d'arriver à cet objectif, on utilise une méthode d'optimisation sous contraintes. Avec une telle approche, on peut prendre en compte des contraintes sur la stabilité du système. Celles-ci sont par exemple les marges de robustesse, la tolérance aux défauts sur des stabilisateurs ainsi que la gestion des éventuelles reconfigurations du système en cas de défaut dans l'une des charges du réseau. De plus, on utilise comme fonction à minimiser une relation liant l'ensemble des blocs de stabilisation à leur impact sur leur charge respective.

Le choix de l'algorithme d'optimisation est transparent au problème. C'est-à-dire que l'intérêt de la méthode proposée ici réside dans la définition du problème. La résolution se fait ensuite à l'aide de l'algorithme d'optimisation sous contraintes choisi par chacun. Ici, la méthode utilisée est la fonction *fmincon* de Matlab disponible dans « *l'optimization toolbox* ». Elle se base sur la minimisation de la fonction objectif à laquelle on a ajouté les contraintes pondérées de coefficients. Les coefficients pondérant les contraintes vont faire en sorte que le minimum de la nouvelle fonction ainsi définie ne puisse correspondre aux solutions ne respectant pas les contraintes.

L'optimisation va se baser sur les modèles linéaires ($M_{sain}$, $M_{defaut\ 1}$, $M_{defaut\ sc}$ et $M_{defaut\ 2}$) correspondant aux différents scénarios possibles dans l'exemple décrit ci-dessus.

Les impédances sont déterminées grâce à la définition et la résolution d'un problème d'optimisation sous contraintes. Les impédances sont la solution du problème d'optimisation sous contraintes. Elles correspondent aux coefficients K et Cv.

La figure 6 illustre schématiquement les étapes du procédé d'optimisation selon l'invention.

Un utilisateur détermine tout d'abord un domaine D dans lequel les coefficients de correction K seront déterminés. L'algorithme d'optimisation va définir dans ce domaine un vecteur $X_o$ comportant l'ensemble des coefficients de correction des charges (bloc 80). Dans le cas présent d'un réseau DC à trois charges, $X_o = [K_1, K_2$ et $K_{sc}]$. L'algorithme d'optimisation va dans un premier temps vérifier que toutes les contraintes précitées sont respectées pour le vecteur $X_o$ (bloc 82). Si les contraintes ne sont pas respectées, l'algorithme va définir un nouveau vecteur (84, 80). Si, au contraire, toutes les contraintes sont respectées. L'algorithme va calculer la fonction objectif avec le vecteur $X_o$ (bloc 86) puis va comparer le résultat obtenu à un résultat de cette même fonction lorsque le vecteur utilisé est le plus petit possible, c'est-à-dire que les coefficients de correction qui le composent sont les plus petits possibles (bloc 88). Si la fonction objectif fobj ($X_o$) est supérieure ou égale à fobj ($X_{min}$) (branches 90, 84), l'algorithme va calculer un nouveau vecteur et réitérer les étapes des blocs 80, 82 et 86. Lorsque la fonction objectif fobj ($X_o$) est inférieure à fobj ($X_{min}$) et que $X_o$ est égal à $X_{min}$, c'est-à-dire que le vecteur est le plus petit possible (bloc 92), l'optimisation est terminée (branche 94) et le vecteur identifié peut être considéré comme le vecteur d'optimisation ($X_o = X_{min} = X_{opt}$ - bloc 96), ce vecteur d'optimisation comportant les coefficients de correction $K_1$, $K_2$ et $K_{sc}$ optimaux pour la stabilisation de l'ensemble des charges et du réseau DC.

Afin de mettre en place le système de stabilisation multi-blocs, la principale étape consiste à obtenir les valeurs de coefficients K qui respecteront les contraintes fixées. Pour cela, le problème d'optimisation sous contraintes défini précédemment à été adapté à la mise en forme demandée par la fonction *fmincon* de Matlab et détaillé ci-dessous :

$$X = \textit{fmincon}\ (fmin,\ x_0,\ A,\ b,\ A_{eq},\ b_{eq},\ x_{min},\ x_{max},\ NL_{con})$$

$f_{min}$: fonction objectif
$x_0$ : point de départ de l'optimisation
A et b : contrainte inégalité, $A.x \leq b$
$A_{eq}$ et $b_{eq}$ : contrainte égalité, $A_{eq}.x = b_{eq}$
Xmin et xmax: intervalles de définition de x
$NL_{con}$ : contraintes inégalité et égalité non-linéaires.

Pour le problème que l'on traite ici, seules les contraintes non-linéaires ($NL_{con}$) sont présentes. Elles seront définies dans un fichier Matlab qui déterminera les valeurs propres des matrices $M_{sain}$, $M_{defaut1}$, $M_{defautsc}$ pour les cas considérés et proposera les contraintes telles qu'elles sont définies plus haut à l'algorithme d'optimisation.

Les vecteurs $x_{min}$ et $x_{max}$ définissent les valeurs maximales et minimales que peuvent prendre les coefficients K. Ici, pour les trois coefficients, on fixera la valeur de la résistance virtuelle (qui correspond à 1/K entre l'infini (pas d'amortissement) et 1. Ceci définit donc $x_{min} = 0$ et $X_{max} = 1$.

Le point initial de l'optimisation $x_0$ sera pris pour placer la valeur initiale de la résistance virtuelle de chaque bloc de stabilisation à 20, c'est-à-dire : $x_0 = [0{,}05\ 0{,}05\ 0{,}05]^t$. La marge de robustesse (MR) sera elle prise égale à 5.

En ce qui concerne le choix des coefficients $a_i$ qui définissent la fonction objectif à minimiser, on prend $a_{sc}$ de signe négatif et on prend $a_1 = a_2$ de signe positif pour avoir $f_{min}$ de la forme :

$$f_{min}\,(K_1, K_2, K_{sc}) = -\,|a_{sc}|K_{sc} + |a_1|(K_1 + K_2)$$

$$|a_{sc}| + 2\,|a_1| = 1.$$

Ceci va permettre de favoriser les "grandes" valeurs de $K_{sc}$ et à l'inverse, de chercher les plus petites valeurs possibles pour $K_1$ et $K_2$. Le rapport $r_{opt} = a_1/a_{sc}$ va permettre de pondérer l'effort d'optimisation. Plus celui-ci sera élevé, plus les coefficients des charges 1 et 2 seront faibles.

Les résultats de l'optimisation (en fonction du rapport $r_{opt}$ pour les intervalles de puissance $P_1 \in [0;700W]$ et $P_2 \in [0;500W]$) ont montré que $K_{sc}$ est toujours bien supérieur à $K_1$ et $K_2$, ce qui confirme le choix du signe des coefficients.

Ensuite, on voit que la valeur de $K_1$ ne varie quasiment pas avec $r_{opt}$. Ceci est dû à la contrainte donnée par le cas où le stabilisateur de la charge 2 est en défaut. Dans ce cas là, seule la charge 1 et la SC doivent assurer la stabilité du bus. Or, on a vu que, étant donné la structure du réseau, le stabilisateur de la SC n'avait qu'un impact limité sur le déplacement de certaines valeurs propres. Dans ce cas là, la charge 1 doit donc assurer l'essentiel de la stabilisation et ceci fixe la valeur du coefficient $K_1$. En ce qui concerne les autres coefficients, on voit qu'ils diminuent à mesure que la valeur de $r_{opt}$ est abaissée. Pour $r_{opt} < 0,06$, l'algorithme ne converge plus.

Dans l'exemple particulier précité de réalisation de l'invention, à partir des équations ci-dessus, on choisit les coefficients qui viennent terminer le dimensionnement du système de stabilisation multi-blocs :

$$K_{sc} = 0,084$$

$$K_1 = 0,008$$

$$K_2 = 0,0535.$$

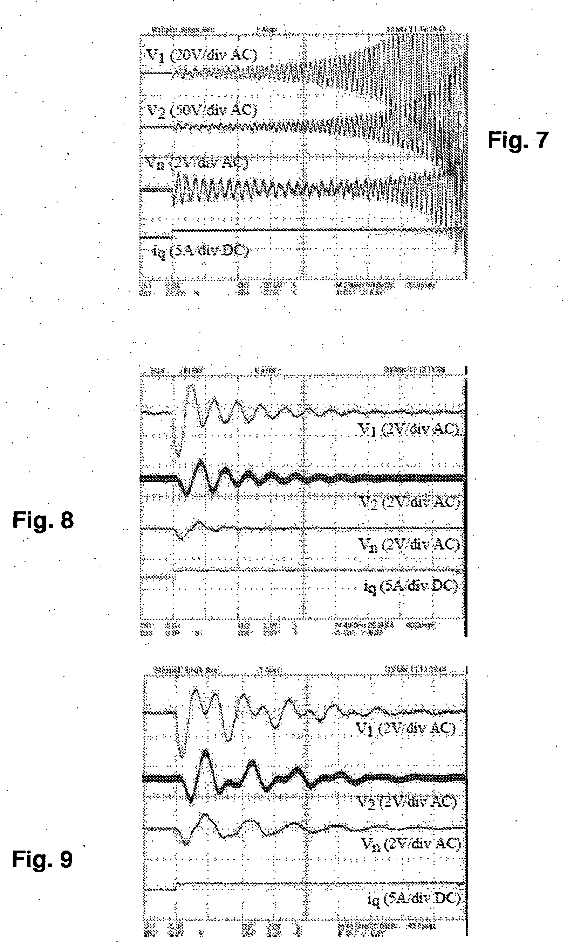

L'efficacité de la stabilisation du réseau DC complet est vérifiée par simulation et expérimentation. Pour cela, un modèle Simulink du réseau peut être dévellopé. Les courbes des figures 7 à 9 ont été obtenues par expérimentation.

La figure 7 est un graphe illustrant l'évolution de la tension de bus DC ($v_1$, $v_2$ et $v_n$) sur les trois charges du réseau de la figure 1 en réponse à un échelon de puissance, lorsque les trois charges ne sont pas stabilisées. On constate que, suite à l'échelon de puissance, les oscillations des signaux ne se stabilisent pas. Au contraire, leurs amplitudes augmentent. Lorsque les valeurs propres de la fonction de transfert $v_n/V_e$ de chaque charge sont étudiées, on constate qu'au moins une partie des zéros du dénominateur de cette fonction de transfert ont une partie réelle positive, ce qui prouve l'instabilité du système.

La figure 8 est un graphe illustrant l'évolution de la tension de bus DC ($v_1$, $v_2$ et $v_n$) sur les trois charges du réseau de la figure 1 en réponse à un échelon de puissance, lorsque ces trois charges sont stabilisées par le procédé selon l'invention. Au contraire de la figure précédente, les oscillations des signaux se stabilisent et leurs amplitudes diminuent au cours du temps, en réponse à un échelon de puissance. Le réseau DC est donc stabilisé.

Lorsque les valeurs propres de la fonction de transfert $v_n/V_e$ de chaque charge sont étudiées, on constate que les zéros du dénominateur de cette fonction de transfert sont tous à partie réelle négative, ce qui prouve la stabilité du réseau quand les trois branches fonctionnent simultanément.

La figure 9 est un graphe correspondant à la figure 8 et pour lequel le bloc de stabilisation de la charge SC est mis en défaut et n'assure donc plus sa stabilisation. On constaté toutefois que les oscillations des signaux se stabilisent et leurs amplitudes diminuent au cours du temps, en réponse à un échelon de puissance. Le réseau DC reste donc stabilisé malgré la désactivation d'un bloc de stabilisation.

Ces résultats confirment l'impact stabilisant de la méthode proposée. On voit que, avec un seul dimensionnement des différents blocs de stabilisation du système, on peut assurer la stabilité du réseau en cas de défaut de l'un des blocs ou en cas de reconfiguration de celui-ci. Ceci est d'autant plus confirmé par le fait que les scénarios qui n'ont pas été intégrés dans les contraintes de l'optimisation sont instables. Le système multi-blocs ne parvient alors pas à assurer la stabilité du système si les contraintes liées au scénario correspondant n'ont pas été prises en compte dans l'optimisation.

Les allures observées sur les résultats de simulation sont toujours présentes sur les essais expérimentaux. On a constaté que le scénario le plus contraignant (celui où la réponse du système est la moins amortie) est celui qui arrive quand le stabilisateur 1 tombe en panne. A l'inverse, le cas le moins contraignant est celui qui arrive quand le stabilisateur de la SC est en défaut.

**Revendications**

1. Procédé de stabilisation d'un réseau électrique (10) DC, ce réseau comportant une source de tension continue (11) alimentant des charges électriques (12, 18, 24) qui sont branchées en parallèle aux bornes de la source de tension et qui sont chacune destinées à recevoir une consigne de courant ou de puissance, **caractérisé en ce que** le réseau est stabilisé par régulation des consignes appliquées aux charges au moyen d'une impédance virtuelle de stabilisation générée aux bornes de chaque charge, ces impédances virtuelles étant dimensionnées pour stabiliser le réseau dans différents points de fonctionnement désirés et dans différentes configurations données du réseau comprenant l'état où au moins une charge est inactive ou en panne et l'état où la stabilisation d'une charge est inactive, chaque impédance virtuelle étant générée au moyen d'un bloc de stabilisation d'une boucle de régulation non linéaire qui agit sur la consigne de la charge correspondante et qui est apte à générer un signal de stabilisation $p_v(t)$ destiné à être superposé à la consigne de la charge pour augmenter le seuil de cette consigne au-delà duquel le réseau est instable, le signal de stabilisation étant du type

$$p_v(t) = v_s(t).C_v.dv_s/dt$$

ou

$$p_v(t) = K.v_s^2 - X_3$$

dans lesquelles $v_s$ représente la tension aux bornes de la charge, $C_v$ et K sont des paramètres définissant l'impédance virtuelle de stabilisation et $X_3$ est le signal de sortie d'un filtre de fréquence de coupure wc qui reçoit en entrée le signal $K.v_s^2$,
plus le paramètre $C_v$ ou K est important et plus le signal de stabilisation est important, ce qui augmente le seuil de la consigne de la charge et garantit la stabilité du réseau.

2.  Procédé selon la revendication 1 , **caractérisé en ce que** chaque boucle de régulation utilise une loi non linéaire de régulation générant un signal de sortie du type K.f(x), x étant une variable de commande de la charge et K étant un coefficient de correction propre à cette charge, les coefficients de correction ($K_i$, $K_2$, $K_n$) étant déterminés en effectuant les étapes consistant à :

    a) définir un modèle mathématique du réseau électrique, ce modèle comportant des équations comprenant les coefficients de correction (Ki , $K_2$, $K_n$) précités pour assurer la stabilité des charges et du réseau ;
    b) définir des contraintes à respecter pour que le réseau reste stable, notamment lors de reconfiguration du réseau ou de défaut d'au moins une charge ; et
    c) déterminer un vecteur ($X_0$) optimal de coefficients de correction au moyen d'un algorithme d'optimisation destiné à vérifier le respect des contraintes précitées pour un vecteur donné et à calculer une fonction objectif de stabilisation avec ce vecteur, puis à répéter ces étapes jusqu'à ce qu'un vecteur dont les coefficients de correction sont les plus faibles possibles satisfasse aux critères.

3.  Procédé selon la revendication 2, **caractérisé en ce que** les contraintes à respecter comprennent des plages de valeurs tolérées pour les coefficients de correction et le maintien de la stabilisation en cas de reconfiguration du réseau, de défaut de stabilisation d'au moins une charge, et de variations ou imprécisions dans les valeurs paramétriques propres au réseau.

4.  Procédé selon la revendication 2 ou 3, **caractérisé en ce que** le modèle mathématique comprend des équations caractérisant le réseau en l'absence d'une ou plusieurs charges et/ou en l'absence de la stabilisation d'une ou plusieurs charges.

5.  Procédé selon l'une des revendications 2 à 4, **caractérisé en ce que** l'algorithme d'optimisation est destiné à comparer le calcul de la fonction objectif avec un vecteur au calcul de cette fonction avec un autre vecteur dont les coefficients de correction sont les plus faibles possibles, puis à répéter ces étapes jusqu'à ce que le vecteur considéré soit identique au vecteur dont les coefficients sont les plus faibles possibles.

6.  Réseau électrique (10) du type DC, comportant une source de tension continue (11) alimentant des charges électriques (12, 18, 24) qui sont branchées en parallèle aux bornes de la source de tension et qui sont chacune destinées à recevoir une consigne de courant ou de puissance, **caractérisé en ce que** le réseau est stabilisé par régulation des consignes appliquées aux charges au moyen de blocs de stabilisation (28) implantés dans des boucles de régulation non linéaire, chaque bloc de stabilisation étant destiné à générer une impédance virtuelle de stabilisation à une dite charge et ayant une entrée reliée à des moyens de mesure de la tension aux bornes de la charge correspondante et une sortie reliée à une borne d'application de la consigne de la charge par un sommateur (36) relié également à des moyens d'émission d'une consigne, les impédances virtuelles étant dimensionnées pour stabiliser le réseau dans différents points de fonctionnement désirés et dans différentes configurations données du réseau comprenant l'état où au moins une dite charge est inactive ou en panne et l'état où la stabilisation d'une dite charge est inactive, chaque impédance virtuelle étant générée au moyen d'un bloc de stabilisation d'une boucle de régulation non linéaire qui agit sur la consigne de la charge correspondante et qui est apte à générer un signal de stabilisation pv(t) destiné à être superposé à la consigne de la charge pour augmenter le seuil de cette consigne au-delà duquel le réseau est instable, le signal de stabilisation étant du type

$$p_v(t) = v_s(t).C_v.dv_s/dt$$

ou

$$p_v(t) = K.v_s^2 - X_3$$

dans lesquelles vs représente la tension aux bornes de la charge, $C_v$ et K sont des paramètres définissant l'impédance virtuelle de stabilisation et $X_3$ est le signal de sortie d'un filtre de fréquence de coupure $w_c$ qui reçoit en entrée le signal $K.v_s^2$,
plus le paramètre $C_v$ ou K est important et plus le signal de stabilisation est important, ce qui augmente le seuil de la consigne de la charge et garantit la stabilité du réseau.

**7.** Réseau selon la revendication 6 **caractérisé en ce que** le bloc de stabilisation (28) comprend un filtre passe bas (32) et un soustracteur (34), l'entrée du filtre étant reliée auxdits moyens de mesure et sa sortie étant reliée au soustracteur qui est destiné à soustraire le signal de sortie du filtre du signal provenant des moyens de mesure.

**8.** Moyen de transport, tel qu'un aéronef, **caractérisé en ce qu'**il comprend un réseau électrique (10) selon la revendication 6 ou 7.


**Patentansprüche**

**1.** Stabilisierungsverfahren eines Gleichstromnetzes (10), wobei dieses Netz eine Gleichstromquelle (11) umfasst, die elektrische Ladungen (12, 18, 24) versorgt, die parallel zu den Klemmen der Spannungsquelle angeschlossen sind und jeweils dazu bestimmt sind, einen Strom- oder Leistungssollwert aufzunehmen, **dadurch gekennzeichnet, dass** das Netz per Regulierung der auf die Lasten mittels einer virtuellen Stabilisierungsimpedanz angewandten Sollwerte stabilisiert ist, die an den Klemmen jeder Last generiert ist, wobei diese virtuellen Impedanzen dimensioniert sind, um das Netz in den unterschiedlichen gewünschten Betriebspunkten und in den unterschiedlichen bestimmten Konfigurationen des Netzes zu stabilisieren, das den Zustand, in dem wenigstens eine Last inaktiv oder ausgefallen ist und den Zustand, in dem die Stabilisierung einer Last inaktiv ist, umfasst, wobei jede virtuelle Impedanz mittels eines Stabilisierungsblocks einer nicht linearen Regulierungsschleife generiert ist, die auf den Sollwert der entsprechenden Last einwirkt und die geeignet ist, ein Stabilisierungssignal $p_v(t)$ zu generieren, das dazu bestimmt ist, dem Sollwert der Last überlagert zu werden, um den Schwellenwert dieses Sollwertes zu erhöhen, über den hinaus das Netz instabil ist, wobei das Stabilisierungssignal von dem Typ ist

$$p_v(t) = v_s(t).C_v dv_s/dt$$

oder

$$p_v(t) = K.v_s^2 - X_3$$

bei denen $v_s$ die Spannung an den Klemmen der Last darstellt, $C_v$ und K Parameter sind, die die virtuelle Stabilisierungsimpedanz definieren und $X_3$ das Ausgangssignal eines Abschaltfrequenzfilters $w_c$ ist, der am Eingang das Signal $K.v_s^2$ empfängt,
je höher der Parameter $C_v$ oder K ist, desto höher ist das Stabilisierungssignal, was den Schwellenwert des Sollwertes der Last erhöht und die Stabilität des Netzes garantiert.

**2.** Verfahren gemäß Anspruch 1, **dadurch gekennzeichnet, dass** jede Regulierungsschleife ein nicht lineares Regulierungsgesetz verwendet, das ein Ausgangssignal von dem Typ K.f(x) generiert, wobei x eine Steuervariable der Last ist und K ein dieser Last eigener Korrekturkoeffizient ist, wobei die Korrekturkoeffizienten ($K_1$ $K_2$, ..., $K_n$) per Durchführung der Stufen bestimmt werden, bestehend aus:

a) Definieren eines mathematischen Modells des Stromnetzes, wobei dieses Modell Gleichungen umfasst, umfassend die vorgenannten Korrekturkoeffizienten ($K_1$, $K_2$, ..., $K_n$) , um die Stabilität der Lasten und des Netzes zu gewährleisten;

b) Definieren von zu beachtenden Beanspruchungen, damit das Netz stabil bleibt, insbesondere bei der Konfiguration des Netzes oder des Fehlens wenigstens einer Last; und

c) Bestimmen eines optimalen Vektors ($X_o$) der Korrekturkoeffizienten mittels eines Optimierungsalgorithmus, der zur Überprüfung der Beachtung der vorgenannten Beanspruchungen für einen bestimmten Vektor und zur Berechnung einer Stabilisierungszielsetzungsfunktion mit diesem Vektor bestimmt ist, dann das Wiederholen dieser Stufen, bis ein Vektor, dessen Korrekturkoeffizienten, die so klein wie möglich sind, den Kriterien genügt.

**3.** Verfahren gemäß Anspruch 2, **dadurch gekennzeichnet, dass** die zu beachtenden Beanspruchungen tolerierte Wertebereiche für die Korrekturkoeffizienten und die Aufrechterhaltung der Stabilisierung bei einer Neukonfiguration des Netzes, einer fehlenden Stabilität wenigstens einer Last und Variationen oder Ungenauigkeiten bei den dem Netz eigenen Parameterwerten umfassen.

**4.** Verfahren gemäß Anspruch 2 oder 3, **dadurch gekennzeichnet, dass** das mathematische Modell Gleichungen umfasst, die das Netz bei Fehlen von einer oder mehreren Lasten und / oder bei Fehlen der Stabilisierung einer oder mehrerer Lasten kennzeichnen.

**5.** Verfahren gemäß Anspruch 2 oder 4, **dadurch gekennzeichnet, dass** der Optimierungsalgorithmus dazu bestimmt ist, die Berechnung der Zielsetzungsfunktion mit einem Vektor mit der Berechnung dieser Funktion mit einem anderen Vektor zu vergleichen, dessen Korrekturkoeffizienten so gering wie möglich sind, dann diese Stufen zu wiederholen, bis der betrachtete Vektor mit dem Vektor identisch ist, dessen Koeffizienten so gering wie möglich sind.

**6.** Stromnetz (10) vom Typ Gleichstrom, umfassend eine Gleichstromspannungsquelle (11), die elektrische Ladungen (12, 18, 24) versorgt, die parallel an den Klemmen der Gleichspannungsquelle angeschlossen sind und die jeweils dazu bestimmt sind, einen Strom- oder Leistungssollwert zu empfangen, **dadurch gekennzeichnet, dass** das Netz per Regulierung der Sollwerte stabilisiert ist, die auf die Lasten mittels Stabilisierungsblöcken (28) angewendet sind, welche in den nicht linearen Regulierungsblöcken implantiert sind, wobei jeder Stabilisierungsblock dazu bestimmt ist, eine virtuelle Stabilisierungsimpedanz mit einer genannten Last zu generieren und einen Eingang zu haben, der mit Messmitteln der Spannung an den Klemmen der entsprechenden Last verbunden ist, und einen Ausgang, der an eine Anwendungsklemme des Sollwertes der Last durch einen Summierer (36) verbunden ist, der ebenfalls mit Ausgabemitteln eines Sollwertes verbunden ist, wobei die virtuellen Impedanzen dimensioniert sind, um das Netz in unterschiedlichen gewünschten Betriebspunkten und in unterschiedlichen bestimmten Konfigurationen des Netzes zu stabilisieren, umfassend den Zustand, in dem wenigstens eine genannte Last inaktiv oder ausgefallen ist und den Zustand, in dem die Stabilisierung einer genannten Last inaktiv ist, wobei jede virtuelle Impedanz mittels eines Stabilisierungsblocks einer nicht linearen Regulierungsschleife generiert wird, die auf den Sollwert der entsprechenden Last einwirkt und die geeignet ist, ein Stabilisierungssignal pv(t) zu generieren, das dazu bestimmt ist, dem Sollwert der Last überlagert zu werden, um den Schwellenwert dieses Sollwertes zu erhöhen, über den hinaus das Netz instabil ist, wobei das Stabilisierungssignal von dem Typ ist

$$\mathrm{Pv}(t) = v_s(t) \cdot C_v \cdot dv_s/dt$$

oder

$$\mathrm{Pv}(t) = K \cdot v_s^2 - X_3$$

bei denen vs die Spannung an den Klemmen der Last darstellt, CV und K Parameter sind, die die virtuelle Stabilisierungsimpedanz definieren und $X_3$ das Ausgangssignal eines Abschaltfrequenzfilters $w_c$ ist, der am Eingang das Signal $K \cdot v_s^2$ empfängt,

je höher der Parameter $C_v$ oder K ist, je höher ist das Stabilisierungssignal, was den Schwellenwert des Sollwertes der Last erhöht und die Stabilität des Netzes garantiert.

7. Netz gemäß Anspruch 6, **dadurch gekennzeichnet, dass** der Stabilisierungsblock (28) einen Tiefpassfilter (32) und ein Subtrahierglied (34) umfasst, wobei der Eingang des Filters mit den genannten Messmitteln verbunden ist und sein Ausgang mit dem Subtrahierglied verbunden ist, das dazu bestimmt ist, das Ausgangssignal des Filters des Signals zu subtrahieren, das aus den Messmitteln stammt.

8. Transportmittel, wie z B. ein Luftfahrzeug, **dadurch gekennzeichnet, dass** es ein Stromnetz (10) gemäß Anspruch 6 oder 7 umfasst.

**Claims**

1. A method of stabilizing a DC electricity network (10), the network having a DC voltage source (11) powering electrical loads (12, 18, 24) that are connected in parallel to the terminals of the voltage source and each of which is to receive a current or power setpoint, the method being **characterized in that** the network is stabilized by regulating the setpoints applied to the loads by means of a virtual stabilization impedance generated at the terminals of each load, these virtual impedances being dimensioned so as to stabilize the network in various desired operating points and in various given configurations of the network including the state in which at least one load is inactive or has failed and the state in which the stabilization of a load is inactive, each virtual impedance being generated by means of a stabilization block of a non-linear regulation loop that acts on the setpoint of the corresponding load and that is suitable for generating a stabilization signal $p_v(t)$ for being superposed to the setpoint of the load in order to raise the threshold of the setpoint beyond which the network is unstable, the stabilization signal being of the type:

$$p_v(t) \; = \; v_s(t) . C_v . dv_s/dt$$

or

$$p_v(t) \; = \; K . v_s^2 \; - \; X_3$$

where:

- $v_s$ represents the voltage at the terminals of the load, $C_v$ and K are parameters defining the virtual stabilization impedance, and $X_3$ is the output signal from a filter of cutoff frequency $w_c$ that receives the signal $K.v_s^2$ as input, and
- the higher the parameter $C_v$ or K is and the higher the stabilization signal is, which serves to raise the threshold of the load setpoint and guarantees stability of the network.

2. A method according to claim 1, **characterized in that** each regulation loop uses a non-linear regulation relationship generating an output signal of the type K.f(x), where x is a control variable for the load and K is a correction coefficient specific to said load, the correction coefficients ($K_1$, $K_2$, ..., $K_n$) being determined by performing the steps consisting in:

a) defining a mathematical model of the electricity network, said model comprising equations including the above-mentioned correction coefficients ($K_1$, $K_2$, ..., $K_n$) for ensuring stability of the loads and of the network;
b) defining constraints to be satisfied so that the network remains stable, in particular in the event of the network being reconfigured or in the event of at least one load failing; and
c) determining an optimum vector ($X_0$) of correction coefficients by means of an optimization algorithm for verifying that a given vector satisfies the above-mentioned constraints and calculating a target function of stabilization with said vector, and then repeating these steps until obtaining a vector that satisfies the criteria and that has the smallest possible correction coefficients.

3. A method according to claim 2, **characterized in that** the constraints to be satisfied comprise acceptable ranges of values for the correction coefficients and for maintaining stabilization in the event of:

- the network being reconfigured,
- a failure in the stabilization of at least one load, and
- given variations or inaccuracies in the parametric values specific to the network.

4. A method according to claim 2 or claim 3, **characterized in that** the mathematical model includes equations characterizing the network in the absence of one or more loads and/or in the absence of stabilization for one or more loads.

5. A method according to any one of claims 2 to 4, **characterized in that** the optimization algorithm serves to compare the calculation of the target function using a vector with the calculation of the same function using another vector in which the correction coefficients are the smallest possible, and then in repeating these steps until the vector under consideration is identical to the vector having the smallest possible coefficients.

6. A DC type electricity network (10) comprising a DC voltage source (11) powering electrical loads (12, 18, 24) that are connected in parallel to the terminals of the voltage source and each of which is to receive a current or power setpoint, the network being **characterized in that** it is stabilized by regulating the setpoints applied to the loads by means of stabilization blocks (28) installed in non-linear regulation loops, each stabilization block serving to generate a virtual stabilization impedance for a corresponding load an and an output connected to a terminal for applying the setpoint of the load by a summing circuit (36) that is also connected to means for issuing a setpoint these virtual impedances being dimensioned so as to stabilize the network in various desired operating points and in various given configurations of the network including the state in which at least one said load is inactive or has failed and the state in which the stabilization of a load is inactive, each virtual impedance being generated by means of a stabilization block of a non-linear regulation loop that acts on the setpoint of the corresponding load and that is suitable for generating a stabilization signal $p_v(t)$ for being superposed to the setpoint of the load in order to raise the threshold of the setpoint beyond which the network is unstable, the stabilization signal being of the type:

$$p_v(t) = v_s(t).C_v.dv_s/dt$$

or

$$p_v(t) = K.v_s^2 - X_3$$

where:

- $v_s$ represents the voltage at the terminals of the load, $C_v$ and $K$ are parameters defining the virtual stabilization impedance, and $X_3$ is the output signal from a filter of cutoff frequency $w_c$ that receives the signal $K.v_s^2$ as input, and
- the higher the parameter $C_v$ or $K$ is and the higher the stabilization signal is, which serves to raise the threshold of the load setpoint and guarantees stability of the network.

7. A network according to claim 6, **characterized in that** the stabilization block (28) comprises a lowpass filter (32) and a subtracter (34), the input of the filter being connected to said above-mentioned measurement means and its output being connected to a subtracter that is for subtracting the filter output signal from the signal coming from the measurement means.

8. A transport means, such as an aircraft, **characterized in that** it includes an electricity network (10) according to claim 6 or claim 7.

**Fig. 1**

**Fig. 2**

**Fig. 3**

**Fig. 4a**

**Fig. 4b**

**Fig. 5**

Intervalles tolérés pour les coefficients des stabilisateurs — 60

Définition de la fonction à minimiser Impact sur l'influence de chaque charge sur la stabilisation

68

Utilisation d'un Algorithme d'Optimisation sous contraintes

70

« Marge de Robustesse » sur la stabilité — 62

Gestion des Reconfigurations du réseau — 64

Gestion de la perte d'un des stabilisateurs — 66

Valeurs des coefficients garantissant l'ensemble des contraintes — 72

---

**Fig. 6**

80

non : optimisation finie

Choix d'un nouveau vecteur $X_0=[k1,k2,..kn]$ dans D ? Conditionnée par l'algorithme d'optimisation utilisé

84

$X_{min} = X_{opt}$

96

oui : l'optimisation continue

D = domaine toléré par l'ingénieur pour les coefficients des stabilisateur

Vérification des contraintes pour $X_0$     non

82

oui

Calcul de $f_{obj}(X_0)$

86

90

$f_{obj}(X_0) < f_{obj}(X_{min})$     non

88

oui

$X_0 = X_{min}$

94

92

20

**Fig. 7**

**Fig. 8**

**Fig. 9**

21

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **CÉSPEDÉS et al.** Stabilisation of Constant-Power Load by Passive Impedance Damping. *Applied Power Electronics Conference and Exposition (APEC),* 2010, 2174-2180

- **AWAN et al.** Active Stabilisation of a Poorly Damped Input Filter Supplying a Constant Power Load. *Proc. ECCE'09*
- **LIU et al.** Active Stabilisation of an HVDC Distribution system with Multiple Constant Power Loads. *IEEE Trans. Industrial Electronics,* 2008, vol. 54 (6